(19) **Europäisches Patentamt**
**European Patent Office**
**Office européen des brevets**

(11) **EP 4 671 745 A1**

(12) **EUROPEAN PATENT APPLICATION**
published in accordance with Art. 153(4) EPC

(43) Date of publication:
**31.12.2025 Bulletin 2026/01**

(51) International Patent Classification (IPC):
**G01N 23/04** (2018.01)

(21) Application number: **23943479.8**

(22) Date of filing: **26.12.2023**

(52) Cooperative Patent Classification (CPC):
**G01N 21/01; G01N 21/88; G01N 21/95;
G01N 23/04; G01R 31/36**

(86) International application number:
**PCT/CN2023/141986**

(87) International publication number:
**WO 2025/001008 (02.01.2025 Gazette 2025/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.06.2023 CN 202321708514 U**

(71) Applicant: **Contemporary Amperex Technology
Co., Limited
Ningde, Fujian 352100 (CN)**

(72) Inventors:
• **SHI, Zhimeng
Ningde, Fujian 352100 (CN)**
• **ZHANG, Tao
Ningde, Fujian 352100 (CN)**
• **ZHANG, Fenglin
Ningde, Fujian 352100 (CN)**
• **LIU, Jianlin
Ningde, Fujian 352100 (CN)**

(74) Representative: **Lorenz Seidler Gossel Part. mbB
Widenmayerstr. 23
80538 München (DE)**

(54) **BATTERY INSPECTION APPARATUS, FLAT PANEL DETECTOR, AND BATTERY PRODUCTION DEVICE**

(57) A battery inspection apparatus (400), a flat panel detector (430), and a battery production device. The battery inspection apparatus (400) comprises a bearing assembly (410), a ray source (420), and a flat panel detector (430); the bearing assembly (410) is used for bearing a battery under test (100), the ray source (420) is located at one end of the bearing assembly (410), and the direction in which a detection ray of the ray source (420) is emitted faces the battery under test (100); the flat panel detector (430) is located at the other end of the bearing assembly (410) distant from the ray source (420), the flat panel detector (430) is used for receiving a detection ray that is emitted by the ray source (420) and penetrates through the battery under test (100), the flat panel detector (430) comprises a scintillator layer (431), and the thickness of the scintillator layer (431) is greater than a first preset thickness, so that the density resolution of the flat panel detector (430) is less than 0.5%.

FIG. 4

**Description**

CROSS-REFERENCE

The present application refers to Chinese Patent Application No. 202321708514.3 entitled "BATTERY DETECTION APPARATUS, FLAT PANEL DETECTOR, AND BATTERY PRODUCTION DEVICE" filed on June 30, 2023, which is incorporated herein by reference in its entirety.

TECHNICAL FIELD

The present application relates to the technical field of batteries, and in particular, to a battery detection apparatus, a flat panel detector, and a battery production device.

BACKGROUND

Energy conservation and emission reduction are the key to sustainable development of the automobile industry. Electric vehicles have become an important part of the sustainable development of the automobile industry due to their energy-saving and environmental protection advantages. For electric vehicles, the battery technology is a crucial factor in their development.

As major automobile manufacturers and user groups pay more attention to the safety of electric vehicles, battery manufacturers implement stricter and more comprehensive control over defective batteries that may be produced during the manufacturing process while improving the battery production efficiency. Various internal defects may occur during the production of batteries, which can affect the quality and safety of the batteries. At present, the internal defects of batteries are usually detected by manual visual inspection of the appearance, which may cause the problem of low accuracy. In addition, with the growing diversity of battery application scenarios, the larger size of batteries has become an important trend in the future development of batteries, which puts forward higher requirements for the detection of internal defects of batteries.

SUMMARY

The present application aims to solve at least one of the technical problems existing in the background. Therefore, an objective of the present application is to provide a battery detection apparatus, a flat panel detector, and a battery production device, so as to improve the accuracy of detecting internal defects of batteries.

Embodiments of the first aspect of the present application provide a battery detection apparatus. The battery detection apparatus includes a carrying assembly, a radiation source, and a flat panel detector. The carrying assembly is configured to carry a battery to be detected, the radiation source is located on one side of the carrying assembly, where the radiation source emits a detection radiation in a direction toward the battery to be detected. The flat panel detector is located on the other side of the carrying assembly distal to the radiation source, where the flat panel detector is configured to receive the detection radiation that is emitted by the radiation source and penetrates the battery to be detected, the flat panel detector includes a scintillator layer, and a thickness of the scintillator layer is greater than a first preset thickness, such that a density resolution of the flat panel detector is less than 0.5%.

According to the embodiments of the present application, by adjusting the thickness of the scintillator layer of the flat panel detector to ensure that the density resolution of the flat panel detector is less than 0.5%, the detection capability of the battery detection apparatus is improved, and the compatibility with density resolution requirements for the battery to be detected with a greater thickness can be achieved, which is conducive to improving the accuracy of the detection results of the battery to be detected. Moreover, the detection of batteries to be detected with different specifications can be achieved, such that the economic efficiency of battery detection is taken into account.

In some embodiments, the thickness of the scintillator layer is less than a second preset thickness, such that a ratio $\alpha$ of an output image contrast to an input image contrast of the flat panel detector satisfies: $50\% \leq \alpha < 1$. By reasonably selecting the thickness of the scintillator layer, the density resolution and the spatial resolution of the flat panel detector can be taken into account, thereby enabling the flat panel detector to better adapt to the internal detection of the thick battery to be detected, improving the quality of the detection image, and thus helping to enhance the accuracy of defect detection of the battery to be detected.

In some embodiments, a detective quantum efficiency $\lambda$ of the flat panel detector satisfies: $0.5 \leq \lambda < 1$. By limiting the detective quantum efficiency of the flat panel detector, the sensitivity and density resolution of the flat panel detector can be ensured to a certain extent. This improves the imaging quality of the image, thereby helping to improve the accuracy of detection image recognition and battery detection results.

In some embodiments, the thickness t of the scintillator layer satisfies: $400\ \mu m < t < 1000\ \mu m$. By reasonably

selecting the thickness range of the scintillator layer in the flat panel detector, the performance of the density resolution and the spatial resolution of the flat panel detector can be taken into account, thereby enabling the flat panel detector to adapt to the objects to be detected with various size ranges and expanding the applicable range.

In some embodiments, the thickness t of the scintillator layer satisfies: $600~\mu m \leq t \leq 700~\mu m$. By further selecting an appropriate thickness for the scintillator layer, the requirements for the density resolution and the spatial resolution are more reasonably taken into account while meeting the detection requirement for the size of the detected object. This improves the detection performance of the flat panel detector to meet the quality requirements for the detection image of the battery to be detected within a broader thickness range, thereby helping to improve the accuracy of image recognition and detection results.

In some embodiments, the density resolution $\beta$ of the flat panel detector satisfies: $0 < \beta \leq 0.38\%$. By further limiting the density resolution range of the flat panel detector, the detection capability of the flat panel detector can be better matched with the thickness of the object to be detected, thereby increasing the size range of the battery to be detected compatible with the flat panel detector, reducing the time for device replacement due to insufficient detection precision, and improving the detection efficiency.

In some embodiments, the radiation source is an integrated radiation source, the scintillator layer includes cesium iodide, and the photoelectric conversion layer includes an amorphous silicon thin film transistor. The flat panel detector with a structure composed of cesium iodide and thin film transistor exhibits less photon loss, and thus the detective quantum efficiency of such flat panel detector is relatively high, which can improve the detection efficiency of the flat panel detector.

In some embodiments, a rated voltage V of the radiation source satisfies: $130~kV \leq V \leq 150~kV$, and/or a rated current I of the radiation source satisfies: $300~\mu A \leq I \leq 500~\mu A$. By limiting the type of the radiation tube, the rated voltage V, and the rated current I, the stability and reliability of the radiation source can be taken into account while providing a detection radiation dose that meets the requirements. Meanwhile, the radiation source can cooperate with the flat panel detector to meet the requirements for the detection precision of the battery to be detected within a broader thickness range, thereby improving the detection efficiency and accuracy.

In some embodiments, a maximum size d of a focal spot of the radiation source satisfies: $0 < d \leq 80~\mu m$. By specifically limiting the focal spot size, the detection precision of the battery detection apparatus can be better matched with the size of the detected battery to be detected, thereby improving the detection accuracy and the detection efficiency.

In some embodiments, the battery detection apparatus further includes a processor. The processor is connected to the flat panel detector, and the processor is configured to receive an electric signal from the flat panel detector to output a detection result of the battery to be detected. By configuring the processor to receive the image signals generated by the flat panel detector, recognizing the detection image, and outputting the detection result of the battery to be detected, the internal defects of the battery to be detected can be automatically detected, thereby improving the automation degree and the detection efficiency of the battery detection apparatus.

Embodiments of the second aspect of the present application provide a flat panel detector configured to detect a battery to be detected. The flat panel detector includes a scintillator layer and a photoelectric conversion layer stacked in a thickness direction. The scintillator layer is configured to receive a detection radiation to emit a visible light; the photoelectric conversion layer receives the visible light emitted by the scintillator layer to generate a corresponding electric signal; a thickness of the scintillator layer is greater than a first preset thickness, such that a density resolution of the flat panel detector is less than 0.5%. The flat panel detector in this embodiment can further improve the density resolution under a fixed radiation dose, thereby meeting the detection requirements for the battery to be detected within a large size range, improving the imaging quality of the image, and thus improving the accuracy of detecting the internal defects in the battery to be detected.

In some embodiments, the thickness of the scintillator layer is less than a second preset thickness, such that a ratio $\alpha$ of an output image contrast to an input image contrast of the flat panel detector satisfies: $50\% \leq \alpha < 1$. By further limiting the thickness of the scintillator layer to ensure that the spatial resolution of the flat panel detector meets the preset requirement, the flat panel detector can take into account the density resolution and the spatial resolution, thereby improving the imaging quality of the image.

In some embodiments, the thickness t of the scintillator layer satisfies: $600~\mu m \leq t \leq 700~\mu m$, the detective quantum efficiency $\lambda$ of the flat panel detector satisfies: $0.5 \leq \lambda < 1$, and the density resolution $\beta$ of the flat panel detector satisfies: $0 < \beta \leq 0.38\%$. By selecting an appropriate thickness for the scintillator layer, the flat panel detector can achieve a more balanced detective quantum efficiency, density resolution, and spatial resolution, thereby meeting the detection precision requirement for the battery to be detected with a large thickness, and expanding the application scope of the flat panel detector.

Embodiments of the third aspect of the present application provide a battery production device. The battery production device includes the battery detection apparatus according to the above embodiments.

Embodiments of the fourth aspect of the present application provide a battery detection method using the battery detection apparatus described above. The method includes: conveying the battery to be detected to a detection station;

acquiring a detection image of the battery to be detected; and recognizing the detection image to determine whether a defect exists in the battery to be detected.

The above description is only an overview of the technical solutions of the present application. To more clearly understand the technical means of the present application to enable implementation in accordance with the content of the specification and to make the above and other purposes, features, and advantages of the present application more obvious and easy to understand, the detailed description of the present application is provided below.

BRIEF DESCRIPTION OF THE DRAWINGS

In the drawings, unless otherwise specified, the same reference numerals across a plurality of drawings indicate the same or similar components or elements. These drawings are not necessarily drawn to scale. It should be understood that these drawings depict only some embodiments of the present application and are therefore not to be considered as limiting the scope of the present application.

FIG. 1 is a structural schematic view of a vehicle according to some embodiments of the present application;
FIG. 2 is an exploded structural schematic view of a battery according to some embodiments of the present application;
FIG. 3 is an exploded structural schematic view of a battery cell according to some embodiments of the present application;
FIG. 4 is a structural schematic view of a battery detection apparatus according to some embodiments of the present application;
FIG. 5 is a structural schematic view of a flat panel detector according to some embodiments of the present application;
FIG. 6 is a flowchart of a detection method of a battery detection apparatus according to some embodiments of the present application;
FIG. 7 is a schematic view of a detection image of a battery to be detected according to some embodiments of the present application;
FIG. 8 is a schematic view of a detection image of a battery to be detected according to some other embodiments of the present application; and
FIG. 9 is a schematic view of a detection image of a battery to be detected according to yet some other embodiments of the present application.

Description of the reference numerals:

vehicle 1000;
battery 100, controller 200, motor 300;
case 10, first part 11, second part 12;
battery cell 20, end cover 21, electrode terminal 21a, housing 22, battery cell assembly 23, tab 23a;
battery detection apparatus 400, carrying assembly 410, battery to be detected 411, radiation source 420, detection radiation 421, flat panel detector 430, scintillator layer 431, photoelectric conversion layer 432, and processor 440.

DETAILED DESCRIPTION

Embodiments of the technical solutions of the present application will be described in detail below with reference to the drawings. The following embodiments are only used to more clearly illustrate the technical solutions of the present application, and therefore, are only exemplary and do not limit the claimed scope of the present application.

Unless otherwise defined, all technical and scientific terms used herein have the same meaning as commonly understood by those skilled in the technical field to which the present application belongs. The terms used herein are only used to illustrate the specific embodiments, rather than limit the present application. The terms "include", "comprise", and "provided with", and any variations thereof in the description and claims of the present application and the above drawing description encompass non-exclusive inclusions.

In the description of the embodiments of the present application, technical terms such as "first", "second", and the like are only used to distinguish different objects and should not be interpreted as indicating or implying the relative importance or implicitly indicating the number, particular order, or primary and secondary relationship of the noted technical features. In the description of the embodiments of the present application, unless otherwise specifically defined, "plurality of" means two or more.

Reference in the present application to "embodiment" means that a particular feature, structure, or characteristic described in combination with the embodiment can be included in at least one embodiment of the present application. The references of the word in the context of the specification do not necessarily refer to the same embodiment, nor to separate or alternative embodiments exclusive of other embodiments. It will be explicitly and implicitly understood by those skilled in the art that the embodiments described herein can be combined with other embodiments.

In the description of the embodiments of the present application, the term "and/or" is merely a way to describe the associative relationship between associated objects, indicating that there are three possible relationships. For example, "A and/or B" may denote: the presence of A alone, the simultaneous presence of A and B, and the presence of B alone. In addition, the character "/" herein generally indicates an "or" relationship between the associated objects before and after the "/".

In the description of the embodiments of the present application, the term "plurality of" refers to two or more (including two). Similarly, "plurality of groups" refers to two or more groups (including two groups), and "plurality of pieces" refers to two or more pieces (including two pieces).

In the description of the embodiments of the present application, the technical terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", and the like indicate orientations or positional relationships based on those shown in the drawings. They are merely for the convenience of describing the present application and simplifying the description, rather than indicating or implying that the apparatus or element referred to must have a particular orientation or be constructed and operated in the particular orientation, and thus should not be construed as a limitation to the embodiments of the present application.

In the description of the embodiments of the present application, unless otherwise clearly specified and defined, the technical terms "mount", "interconnect", "connect", "fix", and the like should be interpreted in their broad senses. For example, they may be a fixed connection, a detachable connection, or an integral connection; a mechanical connection or an electrical connection; or a direct connection, an indirect connection via an intermediate, a communication between interiors of two elements, or an interaction between two elements. For those of ordinary skill in the art, the specific meanings of the above terms in the embodiments of the present application can be interpreted according to specific conditions.

At present, judging from the trends in the market, the application of power batteries is becoming increasingly widespread. Power batteries are not only applied in energy storage power systems such as hydropower, thermal power, wind power, and solar power stations, but also widely applied in electric transportation vehicles such as electric bicycles, electric motorcycles, or electric cars, as well as in military equipment, aerospace, and other fields. With the continuous expansion of the application field of power batteries, the market demand for power batteries is also constantly increasing.

The position and state of the electrode plates in the battery cell are crucial for the performance and safety of the battery. Taking a lithium-ion battery as an example, the gap between the cathode electrode plate and the anode electrode plate and the overhang of the anode electrode plate over the cathode electrode plate and in the battery are important factors affecting the safety performance of a wound battery cell. For the gap between the cathode electrode plate and the anode electrode plate: during charging and discharging of the lithium battery, when the gap between the cathode electrode plate and the anode electrode plate is relatively large, lithium ions cannot all be intercalated into anode channels and some lithium ions accumulate, resulting in lithium plating, which poses a relatively high safety risk. Therefore, the gap between the cathode electrode plate and the anode electrode plate in the battery should not be too large. For the overhang of the anode electrode plate over the cathode electrode plate: during charging and discharging of the lithium battery, lithium ions are repeatedly deintercalated between the cathode electrode plate and the anode electrode plate. However, when lithium ions are deintercalated from the cathode but cannot find sufficient anode channels for intercalation, the lithium ions will accumulate, resulting in lithium plating, which poses certain product safety risks. Therefore, it is necessary to ensure that the entire cathode electrode plate is within the coverage of the anode, that is, to ensure that the anode extends beyond the cathode, which means that the overhang of the anode electrode plate over the cathode electrode plate is greater than 0. Therefore, it is necessary to detect the gap and the overhang of the anode electrode plate over the cathode electrode plate in the batteries, so as to find internal defects of the batteries in time and reduce the outflow of defective batteries.

To improve the accuracy of detecting internal defects of the battery, a CCD camera may be employed to take pictures layer by layer to detect the overhang of the anode over the cathode. However, this method often suffers from defocusing at the winding starting and end positions of the electrode plate, making it difficult to recognize defects. In addition, this method cannot detect the overhang state of the anode electrode plate over the cathode electrode plate after the wound battery cell is subjected to procedures such as cold pressing and hot pressing, and cannot detect the gap between the cathode electrode plate and the anode electrode plate.

Based on the above considerations, to address the issue of insufficient accuracy of detecting internal defects of the battery, a radiographic projection detection method may be employed to implement the nondestructive detection in the battery. The battery is placed between a radiation source and a detector, and radiation emitted by the radiation source penetrates the battery in a direction perpendicular to the winding axis of electrode plates of the battery, and then is received by the detector, such that position information and state information of the cathode electrode plate and the anode electrode plate in the battery are obtained, thereby enabling the detection of various defects in the battery.

When the radiation penetrates corners of the battery, the characteristic differences between the cathode electrode plate and the anode electrode plate in the inner winding layers are smaller. As the size of the battery cell becomes larger and the thickness of the battery increases, the characteristic differences between the cathode electrode plate and the anode electrode plate of the battery decrease exponentially in the inner winding layers, which poses a significant challenge for detecting the overhang of the anode electrode plate over the cathode electrode plate and the gap between the cathode electrode plate and the anode electrode plate in the corner regions. To address the issue of insufficient detection precision caused by the excessive thickness of the battery cell, the thickness of the scintillator layer of the flat panel detector can be optimized. The thickness of the scintillator layer is set to be greater than the first preset thickness, such that the density resolution of the flat panel detector is less than 0.5%. In this way, the detection capabilities of the flat panel detector and the battery detection apparatus can be further improved, thereby meeting the detection precision requirements for the battery cell with a relatively large thickness, enabling more accurate recognition of internal defects of the battery cell, particularly the overhang of the anode electrode plate over the cathode electrode plate and the gap between the cathode electrode plate and the anode electrode plate, and improving the accuracy of the detection results.

The flat panel detector, the battery detection apparatus, and the battery production device disclosed in the embodiments of the present application may be used in the battery production and manufacturing process, and the detected or produced battery cell may, but is not limited to be used in, an electric device, such as a vehicle, a ship, or an aircraft. The power system of the electric device may be composed of the battery cell, the battery, or the like disclosed in the present application.

The embodiments of the present application provide an electric device using a battery as a power source. The electric device may be, but is not limited to, a mobile phone, a tablet, a laptop computer, an electric toy, an electric tool, an electric bicycle, an electric vehicle, a ship, a spacecraft, and the like. The electric toys may include stationary or mobile electric toys, such as game consoles, electric car toys, electric ship toys, or electric airplane toys. The spacecrafts may include airplanes, rockets, space shuttles, spaceships, and the like.

In the following embodiments, for ease of description, the present application is illustrated by taking a vehicle 1000 as an example of the electric device according to an embodiment of the present application.

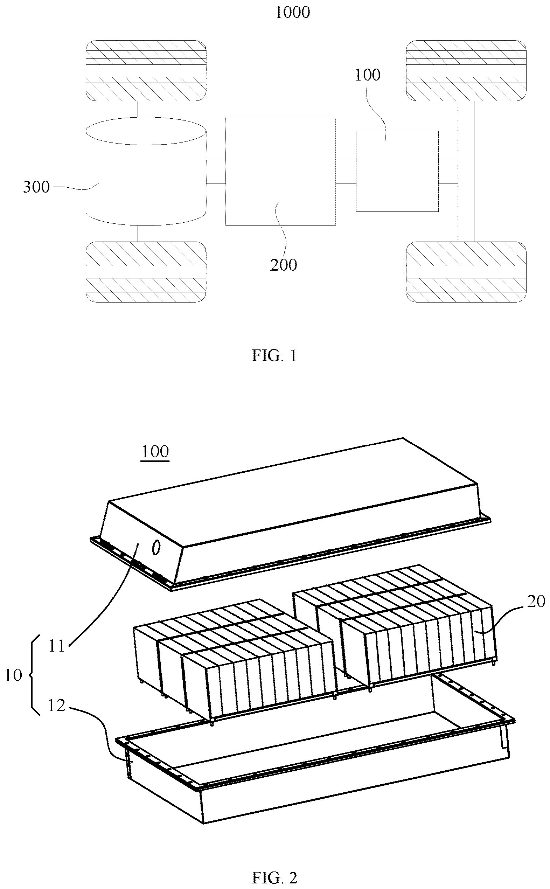

Referring to FIG. 1, FIG. 1 is a structural schematic view of a vehicle 1000 according to some embodiments of the present application. The vehicle 1000 may be a fuel vehicle, a gas vehicle, or a new energy vehicle. The new energy vehicle may be a pure electric vehicle, a hybrid vehicle, an extended-range vehicle, or the like. A battery 100 is provided inside the vehicle 1000, and the battery 100 may be provided at the bottom, head, or tail of the vehicle 1000. The battery 100 may be configured to power the vehicle 1000. For example, the battery 100 may serve as an operation power source of the vehicle 1000. The vehicle 1000 may further include a controller 200 and a motor 300. The controller 200 is configured to control the battery 100 to power the motor 300, e.g., for operation power needed by the vehicle 1000 for start-up, navigation, and driving.

In some embodiments of the present application, the battery 100 may not only serve as an operation power source for the vehicle 1000, but also as a driving power source for the vehicle 1000 to, instead of or in part instead of fuel or natural gas, provide driving power for the vehicle 1000.

Referring to FIG. 2, FIG. 2 is an exploded structural schematic view of a battery 100 according to some embodiments of the present application. The battery 100 includes a case 10 and battery cells 20. The battery cells 20 are accommodated in the case 10. The case 10 is configured to provide an accommodating space for the battery cells 20, and the case 10 may be of a variety of structures. In some embodiments, the case 10 may include a first part 11 and a second part 12. The first part 11 and the second part 12 are mutually lidded onto each other, and the first part 11 and the second part 12 jointly define an accommodating space for accommodating the battery cells 20. The second part 12 may be of a hollow structure with one end open, and the first part 11 may be of a plate-like structure. The first part 11 is lidded onto the open side of the second part 12, such that the first part 11 and the second part 12 jointly define the accommodating space. The first part 11 and the second part 12 may also each be of a hollow structure with one side open, and the open side of the first part 11 is lidded onto the open side of the second part 12. Certainly, the case 10 formed by the first part 11 and the second part 12 may be in various shapes, such as a cylindrical shape and a rectangular parallelepiped shape.

In the battery 100, there may be a plurality of battery cells 20, and the plurality of battery cells 20 may be connected in series, in parallel, or in series-parallel. The series-parallel connection means that both series connection and parallel connection are present for the connection among the plurality of battery cells 20. The plurality of battery cells 20 may be directly connected in series, in parallel, or in series-parallel, and then the whole formed by the plurality of battery cells 20 is accommodated in the case 10. Certainly, the situation may be that in the battery 100, the plurality of battery cells 20 are first connected in series, in parallel, or in series-parallel to form battery modules, and then the plurality of battery modules are connected in series, in parallel, or in series-parallel to form a whole and accommodated in the case 10. The battery 100 may further include other structures. For example, the battery 100 may further include a busbar component for achieving electrical connection among the plurality of battery cells 20.

Each battery cell 20 may be a secondary battery or a primary battery; it may also be a lithium-sulfur battery, a sodium-ion battery, or a magnesium-ion battery, but is not limited thereto. The battery cell 20 may be cylindrical, flat, rectangular parallelepiped-shaped, or in other shapes.

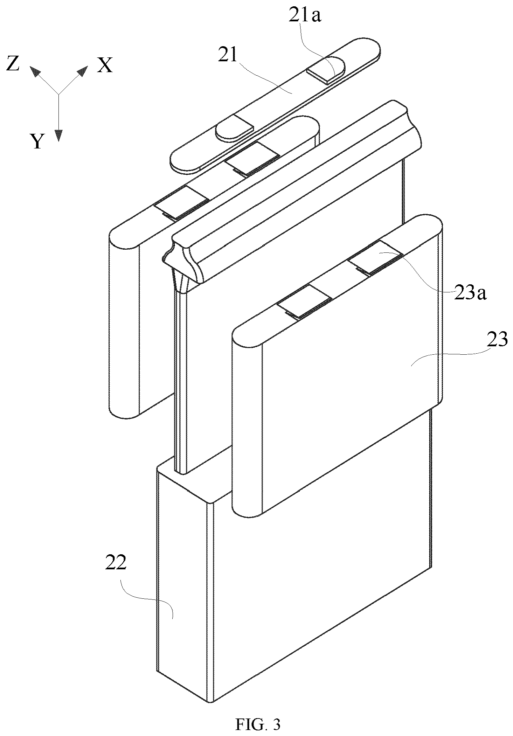

Referring to FIG. 3, FIG. 3 is an exploded structural schematic view of a battery cell 20 according to some embodiments of the present application. The battery cell 20 refers to the smallest unit forming a battery. As illustrated in FIG. 3, the battery cell 20 includes an end cover 21, a housing 22, a battery cell assembly 23, and other functional components.

The end cover 21 is a component that is lidded onto the opening of the housing 22 to isolate the internal environment of the battery cell 20 from the external environment. Without limitation, the shape of the end cover 21 may be adapted to the shape of the housing 22 to match the housing 22. Optionally, the end cover 21 may be made of a material with a certain hardness and strength (for example, an aluminum alloy), such that the end cover 21 is not easily deformed when being squeezed or collided. This enables the battery cell 20 to have higher structural strength, and the safety performance can also be improved. Functional components such as an electrode terminal 21a may be provided on the end cover 21. The electrode terminal 21a may be configured to be electrically connected to the battery cell assembly 23 to output or input the electric energy of the battery cell 20. In some embodiments, the end cover 21 may also be provided with a pressure relief mechanism for releasing the internal pressure when the internal pressure or temperature of the battery cell 20 reaches a threshold. The end cover 21 may also be made of a variety of materials, such as copper, iron, aluminum, stainless steel, aluminum alloy, and plastic, which is not specifically limited in the embodiments of the present application. In some embodiments, an insulating member may also be provided on the inner side of the end cover 21, and the insulating member may be configured to isolate an electrical connection component in the housing 22 from the end cover 21 to reduce the risk of a short circuit. Illustratively, the insulating member may be made of plastic, rubber, or the like.

The housing 22 is a component configured to form the internal environment of the battery cell 20 in combination with the end cover 21. The formed internal environment may be used to accommodate the battery cell assembly 23, electrolyte, and other components. The housing 22 and the end cover 21 may be independent components. An opening may be formed in the housing 22, and the end cover 21 is lidded onto the opening to form the internal environment of the battery cell 20. Without limitation, the end cover 21 and the housing 22 may be integrated. Specifically, the end cover 21 and the housing 22 may form a common connection surface before other components are placed in the housing, and when the interior of the housing 22 needs to be encapsulated, the end cover 21 is lidded onto the housing 22. The housing 22 may be in various shapes and sizes, such as a rectangular parallelepiped, a cylinder, and a hexagonal prism. Specifically, the shape of the housing 22 may be determined based on the specific shape and size of the battery cell assembly 23. The housing 22 may be made of a plurality of materials, such as copper, iron, aluminum, stainless steel, aluminum alloy, and plastic, which is not specifically limited in the embodiments of the present application.

The battery cell assembly 23 is a component where the electrochemical reaction occurs in the battery cell 20. One or more battery cell assemblies 23 may be accommodated in the housing 22. The battery cell assembly 23 is mainly formed by winding or stacking a positive electrode plate and a negative electrode plate, and a separator is generally provided between the positive electrode plate and the negative electrode plate. The portions of the positive electrode plate and the negative electrode plate that contain the active substance constitute the body part of the battery cell assembly, and the portions of the positive electrode plate and the negative electrode plate that do not contain the active substance each constitute a tab 23a. The positive electrode tab and the negative electrode tab may be located together at one end of the body part or separately at two ends of the body part. During charging and discharging of the battery, the positive electrode active substance and the negative electrode active substance react with the electrolyte, and the tabs 23a are connected to the electrode terminals to form a current circuit.

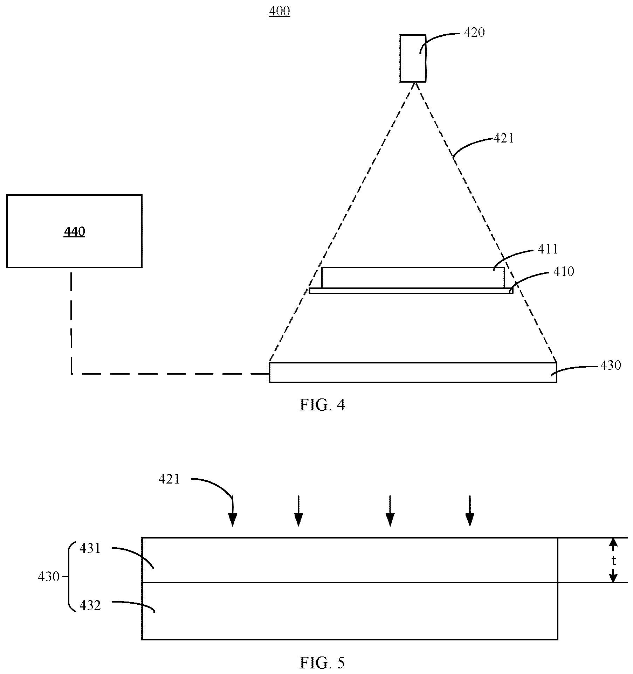

Referring to FIG. 4, FIG. 4 is a structural schematic view of a battery detection apparatus 400 according to some embodiments of the present application. FIG. 5 is a structural schematic view of a flat panel detector 430 according to some embodiments of the present application. The battery detection apparatus 400 includes a carrying assembly 410, a radiation source 420, and a flat panel detector 430.

The carrying assembly 410 is configured to carry a battery to be detected 411. The radiation source 420 is located on one side of the carrying assembly 410, and the radiation source 420 emits a detection radiation 421 in a direction toward a battery cell 410. The flat panel detector 430 is located on the other side of the carrying assembly 410 distal to the radiation source 420. That is, the flat panel detector 430 and the radiation source 420 are located on the two sides of the carrying assembly 410, respectively, such that the flat panel detector 430 can be configured to receive the detection radiation 421 that is emitted by the radiation source 410 and penetrates the battery to be detected 411. The flat panel detector 430 includes a scintillator layer 431, and the thickness of the scintillator layer 431 is greater than a first preset thickness, such that the density resolution of the flat panel detector 430 is less than 0.5%.

The carrying assembly 410 may be any carrying structure that can fix the battery to be detected in a supporting or clamping manner, such as a tray, a gripper, or the like. The carrying assembly 410 may be fixed or movable, for example, a tray or a clamping mechanism that is provided with a conveying track and moves along the conveying track. The number of the battery to be detected 411 carried on the carrying assembly 410 may be one or a plurality. In one example, the carrying assembly 410 may include a plurality of trays, and each tray carries one or more batteries to be detected 411. The battery to be detected 411 may be the battery cell 20 or the battery 100 including a plurality of battery cells 20 according to the above embodiments.

The radiation source 420 serves as an apparatus configured to emit the detection radiation, and is primarily composed of a radiation tube and a corresponding power supply. The detection radiation 421 may be an X-ray or other types of radiation. The radiation tube can emit a corresponding detection radiation, and may be, for example, an X-ray tube or a $\gamma$-ray tube. The radiation source 420 may be open (an open tube) or closed (a closed tube). In one example, the radiation source 420 is an X-ray source, and the detection radiation 421 emitted thereby is an X-ray. When the detection radiation 421 emitted by the radiation source 420 penetrates the battery to be detected 411, the material differences between the cathode electrode plate and the anode electrode plate in the battery to be detected 411 (the anode surface is coated with carbon powder, which has weak absorption of X-rays; the cathode surface is made of lithium-ion material, which has strong absorption of X-rays) lead to different absorption rates of X-rays. In addition, spacings exist between the cathode electrode plate and the anode electrode plate during winding. Therefore, the gap between the cathode electrode plate and the anode electrode plate and the overhang of the anode electrode plate over the cathode electrode plate can be detected based on the differences of the plates in absorption levels of X-rays.

The flat panel detector 430 is a two-dimensional flat panel detector. The flat panel detector 430 may be an indirect flat panel detector. The scintillator layer 431 may be a film layer structure stacked in the thickness direction of the flat panel detector 430. The scintillator layer 431 is a uniform-thickness layer of scintillator material located on the surface on a side facing the radiation source 420, which can receive the X-rays attenuated after penetrating the battery to be detected 411 and convert them into visible light.

The thickness t of the scintillator layer 431 refers to the thickness size in the thickness direction of the flat panel detector 430. It can be understood that in consideration of factors such as manufacturing precision, the value of the thickness t of the scintillator layer 431 may vary at different locations. In this case, the expression that the thickness t of the scintillator layer 431 is greater than the first preset thickness means that even the minimum thickness of the scintillator layer 431 is still greater than the first preset thickness.

The density resolution, also known as low contrast resolution, refers to the capability of resolving the minimum density difference between two tissues in an image under low contrast. Once the degree of gray-scale variation in a region of interest of the detected object, after radiation penetration, is less than the density resolution of the flat panel detector, the flat panel detector will not be able to accurately distinguish the gray-scale variation in the region of interest, which is not conducive to capturing and recognizing image features of the region of interest by an algorithm. The density resolution of the flat panel detector 430 can be determined by the detection method for low-density resolution specified in the industry standard YY/T 0741-2018.

The main factors affecting the density resolution of the flat panel detector 430 include the size of the detected object, noise, and signal-to-noise ratio. The noise and signal-to-noise ratio are determined by the efficiency of the detector and the X-ray dose. A higher efficiency and a higher dose result in a higher signal-to-noise ratio, reduced noise, and an improved density resolution. It can be understood that a smaller density resolution of the flat panel detector 430 results in a higher resolution capability under low contrast and a higher detection precision.

To determine whether the density resolution of the flat panel detector meets the detection requirement of the battery to be detected 411, the density contrast of a single-layer electrode plate in the battery to be detected 411 can be calculated and compared with the density resolution of the flat panel detector 430. For example, in the battery to be detected 411, the density contrast U of the cathode electrode plate in the innermost winding layer can be calculated according to the following formula:

$$U = \frac{[(X_1 - X_2) \times M_1 + \rho_1 \times X_2]}{\{N \times 2 \times [(X_1 - X_2)M_1 + \rho_1 \times X_2] + (N+1) \times 2 \times [(Y_1 - Y_2)M_2 + \rho_2 \times Y_2]\}},$$

where N refers to the number of winding turns of the cathode electrode plate, $X_1$ refers to the cold press thickness of the cathode electrode plate, $X_2$ refers to the thickness of the cathode foil, $\rho_1$ refers to the density of the cathode foil, $M_1$ refers to the compaction density of the cathode electrode, $Y_1$ refers to the cold press thickness of the anode electrode plate, $Y_2$ refers to the thickness of the anode foil, $\rho_2$ refers to the density of the anode foil, and $M_2$ refers to the compaction density of the anode electrode.

The density contrast U of the cathode electrode plate in the innermost winding layer of the battery is negatively correlated with the number of winding turns N of the cathode electrode plate. A larger number of winding turns N of the cathode electrode plate results in a smaller density contrast U of the cathode electrode plate. When the density contrast U of the cathode electrode plate is lower than the density resolution of the flat panel detector 430, the flat panel detector 430 will fail to accurately display the gray-scale variation of the cathode electrode plate in the innermost winding layer of the battery in the image, which is not conducive to the detection of internal defects of the battery, such as the overhang of the anode electrode plate over the cathode electrode plate or the gap between the cathode electrode plate and the anode electrode plate.

In some examples, the thickness t of the scintillator layer 431 of the flat panel detector 430 is 400 microns ($\mu$m),

and the density resolution is 0.5%. When the number of winding turns N of the cathode electrode plate is 47, the density contrast U of the cathode electrode plate in the innermost circle is 0.53%, which is greater than the density resolution of the flat panel detector 430. This indicates that the flat panel detector 430 can meet the detection requirement of the cathode electrode plate in the innermost winding layer of the battery to be detected 411. When the number of winding turns N of the cathode electrode plate is 76, the density contrast U of the cathode electrode plate in the innermost circle is 0.39%, which is lower than the density resolution of the flat panel detector 430.

Increasing the radiation dose requires increasing the power of the radiation source, which will increase the workload of the radiation source. Meanwhile, increasing the power of the radiation source results in an increase in the focal spot size of the radiation source. A larger focal spot size results in a lower resolution of the flat panel detector. The increase in the thickness of the scintillator layer 431 can improve the conversion efficiency for X-rays. Under the same dose, the flat panel detector 430 with a thicker scintillator layer 431 generates more photon signals through conversion, thereby making the gray-scale value difference between the cathode electrode plate and the anode electrode plate in the inner winding layer more significant. When the number of winding turns of the cathode electrode plate in the battery to be detected 411 is further increased, the thickness of the scintillator layer 431 of the flat panel detector 430 can be increased. This reduces the density resolution of the flat panel detector 430, thereby meeting the density resolution requirements for detecting ultra-thick batteries to be detected.

By adjusting the thickness of the scintillator layer 431 of the flat panel detector 430 to ensure that the density resolution of the flat panel detector 430 is less than 0.5%, the detection capability of the battery detection apparatus 400 is improved, and the thickness size range of the battery to be detected that can meet the density resolution requirements is expanded, which is conducive to improving the accuracy of the detection results of the battery to be detected 411. Moreover, the detection of batteries to be detected with different specifications can be achieved, such that the economic efficiency of battery detection is taken into account.

According to some embodiments of the present application, the thickness t of the scintillator layer 431 is less than the second preset thickness, such that the ratio $\alpha$ of the output image contrast to the input image contrast of the flat panel detector 430 satisfies: $50\% \leq \alpha < 1$.

The ratio of the output image contrast to the input image contrast of the flat panel detector 430 may be represented by a modulation transfer function (MTF) of the flat panel detector 430. The MTF is used to describe the capability of the system to reproduce the spatial frequency range of an imaging object, reflecting the spatial resolution of the imaging system. When reproducing the details of the imaging object, the flat panel detector 430 inevitably exhibits a certain degree of attenuation; that is, the images obtained by the imaging system suffer varying degrees of loss in image contrast. Therefore, the MTF is always less than 1. A higher MTF results in a stronger capability of the flat panel detector 430 to reproduce the details of the imaging object.

The MTF of the flat panel detector 430 can be obtained by measurement, for example, by using the boundary method. The increase in the thickness of the scintillator layer 421 helps to improve the density resolution of the flat panel detector, but also leads to a decrease in the MTF and spatial resolution, thereby diminishing the image detail resolution capability of the flat panel detector and resulting in more blurred edge features of the detected object. When the battery to be detected 411 is detected, both the density resolution and the spatial resolution need to meet certain requirements to improve the accuracy of the detection results. Therefore, during the design of the thickness of the scintillator layer 431 of the flat panel detector 430, the MTF of the flat panel detector needs to be taken into account to meet the requirements for detection precision.

By reasonably selecting the thickness of the scintillator layer 431, the density resolution and the spatial resolution of the flat panel detector 430 can be taken into account, thereby enabling the flat panel detector to better adapt to the internal detection of thicker batteries to be detected, improving the quality of the detection image, and thus helping to enhance the accuracy of defect detection of the battery to be detected.

According to some embodiments of the present application, the detective quantum efficiency $\lambda$ of the flat panel detector 430 satisfies: $0.5 \leq \lambda < 1$.

Detective quantum efficiency (DQE), expressed in percentage, quantifies the capability of the imaging system to transfer signal and noise from input to output. The DQE reflects the sensitivity, noise, X-ray dose, and density resolution of the flat panel detector. The flat panel detector with higher DQE can achieve better image quality at a lower radiation dose. The DQE $\lambda$ can be expressed as follows:

$$\lambda = \left(\frac{\text{Signal-to-noise ratio of the output image}}{\text{Signal-to-noise ratio of the input image}}\right)^2.$$

A higher DQE $\lambda$ value (with a maximum of 1, indicating 100% utilization) signifies a higher effective quantum utilization rate and a higher signal-to-noise ratio in the output image. As the thickness of the scintillator layer increases, the conversion efficiency of the radiation under the same incident dose can be improved, resulting in a higher signal-to-noise ratio in the output image. This enhances the DQE $\lambda$ value and improves the density resolution of the flat panel detector 430, thereby facilitating better detection of low contrast features.

In some examples, the DQE of the flat panel detector may be measured according to the measurement method specified in the standard IEC 62220-1 formulated by the International Electrotechnical Commission, or may be measured according to the measurement method specified in applicable industry standards. In some other examples, the DQE may also be determined according to the following calculation formula:

$$\lambda = S^2 \times MTF^2 / NPS \times X \times C$$ ,

where S refers to the average signal intensity; MTF refers to the modulation transfer function; X refers to the radiation exposure intensity; NPS refers to the system noise power spectrum; and C refers to the radiation quantum coefficient.

By limiting the DQE of the flat panel detector 430, the sensitivity and density resolution of the flat panel detector 430 can be ensured to a certain extent. This improves the imaging quality of the image, thereby helping to improve the accuracy of detection image recognition and battery detection results.

According to some embodiments of the present application, the thickness t of the scintillator layer 431 satisfies: 400 μm < t < 1000 μm.

An insufficient thickness of the scintillator layer 431 affects the density resolution and the quantum detection efficiency of the flat panel detector 430, whereas an excessive thickness of the scintillator layer 431 affects the MTF of the flat panel detector 430, thereby affecting the spatial resolution of the flat panel detector 430. In some examples, the thickness of the scintillator layer 431 is 400 μm, the density resolution of the flat panel detector 430 is 0.5%, the quantum detection efficiency is 0.5 to 0.7, and the MTF measured by the boundary method is 72%. This configuration meets the detection requirements for the objects to be detected requiring a density resolution of 0.5% or higher, making it suitable for, e.g., the detection of the overhang of the anode electrode plate over the cathode electrode plate or the gap between the cathode electrode plate and the anode electrode plate in the innermost winding layer of the battery to be detected 411 with 47 or fewer electrode plate winding turns. In some embodiments, the first preset thickness may be 400 μm, and may be used in combination with other parameters, such as the voltage or current of the radiation source, such that the density resolution, MTF, and quantum detection efficiency of the flat panel detector can meet the corresponding requirements. When the thickness of the scintillator layer 431 exceeds 1000 μm, although the density resolution of the flat panel detector 430 is high, the MTF is significantly reduced, which limits the spatial resolution of the flat panel detector and is not conducive to imaging. Optionally, the thickness t of the scintillator layer 431 may be 500 μm, 600 μm, or 700 μm.

By reasonably selecting the thickness range of the scintillator layer 431 in the flat panel detector 430, the performance of the density resolution and the spatial resolution of the flat panel detector 430 can be taken into account, thereby enabling the flat panel detector to better adapt to the objects to be detected with various size ranges and expanding the applicable range.

According to some embodiments of the present application, the thickness t of the scintillator layer 431 satisfies: 600 μm ≤ t ≤ 700 μm.

By further selecting an appropriate thickness for the scintillator layer 431, the requirements for the density resolution and the spatial resolution are more reasonably taken into account while meeting the detection requirement for the size of the detected object. This improves the detection performance of the flat panel detector 430 to meet the quality requirements for the detection image of the battery to be detected 411 within a broader thickness range, thereby helping to improve the accuracy of image recognition and detection results. Optionally, the thickness t of the scintillator layer 431 may be 600 μm, 650 μm, or 700 μm.

According to some embodiments of the present application, the density resolution β of the flat panel detector 430 satisfies: 0 < β ≤ 0.38%.

A smaller density resolution results in a higher density resolution capability of the flat panel detector 430 and a higher detection precision. In this way, the precision requirements for detecting the ultra-thick battery to be detected 411 can be better met. For example, if the number of winding turns of the cathode electrode plate in the battery to be detected 411 is 76 and the corresponding density contrast U is 0.39%, the flat panel detector 430 must have a density resolution of no more than 0.39% to ensure that the flat panel detector 430 can distinguish between the cathode electrode plate and the anode electrode plate in the innermost winding layer. In this way, the detection requirements for the battery to be detected 411 with no more than 76 electrode plate winding turns can be better met. It can be understood that although the density resolution of the flat panel detector 430 is negatively correlated with the thickness of the scintillator layer, the influence factors that determine the density resolution are not limited to the thickness of the scintillator layer. This means that when the thickness of the scintillator layer is fixed, the density resolution β can be made to satisfy 0 < β ≤ 0.38% by adjusting other parameters, such as adjusting the X-ray dose or reducing the focal spot size.

By further limiting the density resolution range of the flat panel detector 430, the detection capability of the flat panel detector 430 can be better matched with the thickness of the object to be detected, thereby increasing the size range of the battery to be detected 411 compatible with the flat panel detector 430, reducing the time for device replacement due to insufficient detection precision, and improving the detection efficiency.

According to some embodiments of the present application, the scintillator layer 431 includes cesium iodide, and the photoelectric conversion layer 432 includes an amorphous silicon thin film transistor.

The flat panel detector 430 is an indirect flat panel detector. The flat panel detector 430 may include a photoelectric conversion layer 432 and a scintillator layer 431 that are sequentially stacked on a substrate. The scintillator layer 431 is located on a surface on a side facing the radiation source 420, so as to receive the detection radiation penetrating the battery to be detected 411 and generate visible photons. Cesium iodide is an inorganic scintillation crystal that can absorb radiation energy to emit fluorescent photons. It has the advantages of high radiation detection efficiency and high luminous efficiency, and emits light with a spectral wavelength well-matched with that of silicon photodiodes. Due to its higher sensitivity, a lower X-ray dose is required, resulting in higher safety performance.

The flat panel detector with a structure composed of cesium iodide and thin film transistor exhibits less photon loss, and thus the DQE of such flat panel detector 430 is relatively high, which can improve the detection efficiency of the flat panel detector 430.

According to some embodiments of the present application, the radiation source is an integrated radiation source, and the rated voltage V of the radiation source satisfies: 130 kilovolts (kV) $\leq$ V $\leq$ 150 kilovolts (kV), and/or the rated current I of the radiation source satisfies: 300 microamperes ($\mu$A) $\leq$ I $\leq$ 500 microamperes ($\mu$A).

The integrated radiation source is a closed radiation source, which adopts an integrated design in which the cathode and the anode/target are enclosed in a vacuum tube. This design not only increases the stability and reduces the repair rate, but also allows the radiation source to have a small volume, thereby facilitating the operation and installation.

The maximum radiation photon energy emitted by the radiation source 420 is equal to the energy obtained by incident electrons in the accelerating electric field of the radiation tube, i.e., the product of the electron charge and the voltage of the accelerating electric field. The voltage of the accelerating electric field is the tube voltage, which corresponds to the magnitude of the rated voltage V of the radiation source 420. A higher rated voltage V results in a higher energy of the radiation generated, a shorter wavelength, and a greater capability to penetrate substances.

A higher rated current I of the radiation source 420 results in a greater number of high-speed electrons bombarding the target per unit time, such that more radiation is emitted by the radiation source 420 (which corresponds to an increase in the radiation dose for a certain area), and the brightness of the corresponding image is enhanced. However, an excessive rated voltage or rated current of the radiation source 420 results in an excessively large focal spot size of the radiation source 420, thereby reducing the spatial resolution of the flat panel detector 430, which is not conducive to subsequent image recognition and defect determination.

By limiting the type of the radiation tube, the rated voltage V, and the rated current I, the stability and reliability of the radiation source can be taken into account while providing a detection radiation dose that meets the requirements. Meanwhile, the radiation source can cooperate with the flat panel detector to meet the requirements for the detection precision of the battery to be detected within a broader thickness range, thereby improving the detection efficiency and accuracy.

According to some embodiments of the present application, the maximum size d of the focal spot of the radiation source satisfies: 0 < d $\leq$ 80 $\mu$m.

The focal spot size of the radiation source refers to the size of the focal spot in a certain direction parallel to the plane where the focal spot is located. In the case that other conditions are consistent, a smaller focal spot results in a higher resolution and better imaging quality. Common methods for measuring the focal spot size of the radiation source are classified into a direct method and an indirect method. The direct method refers to directly observing the shape, size, and the like of the focal spot, such as a pinhole method. The indirect method refers to observing a point spread function or a line spread function caused by the focal spot size to calculate the focal spot size, including a knife-edge method, a slit method, and a spherical target method. The focal spot size of the radiation source can also be determined with reference to methods specified in relevant measurement standards, such as the measurement methods listed in GB/T 26834-2011.

The focal spot size is directly correlated with the image resolution of the battery detection apparatus. By specifically limiting the focal spot size, the detection precision of the battery detection apparatus can be better matched with the size of the detected battery to be detected, thereby improving the detection accuracy and the detection efficiency.

According to some embodiments of the present application, the battery detection apparatus 400 further includes a processor 440. The processor 440 is connected to the flat panel detector 430, and the processor 440 is configured to receive the electric signal from the flat panel detector 430 to output the detection result of the battery to be detected 411.

The processor 440 may be a computer device, and the processor 440 receives the electric signal from the flat panel detector 430 to restore the image of the detected object. The processor 440 may further preset the corresponding image recognition algorithm. By recognizing the detection image, the corresponding detection result can be obtained. According to the detection result, whether the battery to be detected 411 is abnormal is determined. In one example, the processor 440 can recognize the detection image to acquire parameters such as the overhang of the anode electrode plate over the cathode electrode plate and/or the gap between the cathode electrode plate and the anode electrode plate in the battery to be detected 411, compare these parameters with the preset threshold, and output the corresponding detection result according to the comparison result.

By configuring the processor 440 to receive the image signals generated by the flat panel detector 430, recognizing the detection image, and outputting the detection result of the battery to be detected 411, the internal defects of the battery to be detected can be automatically detected, thereby improving the automation degree and the detection efficiency of the battery detection apparatus.

Embodiments of the second aspect of the present application provide a flat panel detector 430. The flat panel detector 430 includes a scintillator layer 431 and a photoelectric conversion layer 432 stacked in the thickness direction. The scintillator layer 431 is configured to receive the detection radiation 421 to emit visible light; the photoelectric conversion layer 432 receives the visible light emitted by the scintillator layer 431 to generate the corresponding electric signal; the thickness of the scintillator layer 431 is greater than the first preset thickness, such that the density resolution of the flat panel detector 430 is less than 0.5%.

The flat panel detector 430 is arranged on a side of the detection object distal to the radiation source. The flat panel detector 430 is configured to receive the detection radiation 421 that is emitted by the radiation source and penetrates the detection object. The detection object may be the battery to be detected 411. The scintillator layer 431 and the photoelectric conversion layer 432 may be sequentially provided on the base substrate of the flat panel detector 430. The scintillator layer 432 is located on a surface on a side facing the radiation source to receive the detection radiation 421 penetrating the battery to be detected 411 and emit visible light. The photoelectric conversion layer 432 receives the visible light emitted by the scintillator layer 431 to generate the corresponding electric signal.

The photoelectric conversion layer 432 may be a thin film transistor (TFT), a charge coupling device (CCD), or a complementary metal oxide semi-conductor (CMOS). In some examples, the photoelectric conversion layer 432 may include a photodiode circuit and a charge readout circuit. The photodiode circuit converts the visible light emitted by the scintillator layer 431 into electric signals to form stored charges on the capacitor of the photodiode itself. The amount of the stored charges of each pixel is proportional to the intensity of the incident X-ray. The charge readout circuit scans and reads out the stored charges of each pixel under the action of the control circuit. After A/D conversion, digital signals are outputted and transmitted to a computer for image processing, forming an X-ray digital image.

The flat panel detector in this embodiment can further improve the density resolution under a fixed detection radiation dose, thereby meeting the detection requirements for the battery to be detected 411 within a large size range, improving the imaging quality of the image, and thus improving the accuracy of detecting the internal defects of the battery to be detected 411.

In some embodiments, the thickness of the scintillator layer 431 is less than the second preset thickness, such that the ratio $\alpha$ of the output image contrast to the input image contrast of the flat panel detector 430 satisfies: $50\% \leq \alpha < 1$.

By further limiting the thickness of the scintillator layer 431 to ensure that the spatial resolution of the flat panel detector 430 meets the preset requirement, the flat panel detector 430 can take into account the density resolution and the spatial resolution, thereby improving the imaging quality of the image.

In some embodiments, the thickness t of the scintillator layer 431 satisfies: $600\ \mu m \leq t \leq 700\ \mu m$, the DQE $\lambda$ of the flat panel detector 430 satisfies: $0.5 \leq \lambda < 1$, and the density resolution $\beta$ of the flat panel detector satisfies: $0 < \beta \leq 0.38\%$.

By selecting an appropriate thickness for the scintillator layer 431, the flat panel detector 430 can achieve a more balanced DQE, density resolution, and spatial resolution, thereby meeting the detection precision requirement for the battery to be detected with a large thickness, and expanding the application scope of the flat panel detector.

Embodiments of the third aspect of the present application provide a battery production device. The battery production device includes the battery detection apparatus 400 according to the above embodiments.

The battery production device includes a battery detection apparatus 400, which can perform nondestructive detection on the battery to be detected 411 during the production of the battery to be detected 411, to find internal defects of the battery to be detected 411 in time, thereby rejecting unqualified batteries to be detected 411 and improving the quality of the batteries to be detected 411 that are released.

The battery detection apparatus of the present application will be further described below with reference to a specific embodiment.

As illustrated in FIGs. 4 to 6, the battery detection apparatus 400 includes a carrying assembly 410, a radiation source 420, a flat panel detector 430, and a processor 440.

The carrying assembly 410 may be a tray or a gripper-like clamping mechanism for carrying the battery to be detected 411. The carrying assembly 410 may be configured to be movable so as to allow the battery to be detected 411 to move into and out of the detection area between the radiation source 430 and the flat panel detector 430. The carrying assembly 410 may be made of a low-density material, such as carbon fiber, to reduce the absorption of the detection radiation by the carrying assembly 410.

The radiation source 420 is located on one side of the carrying assembly 410, and the radiation source 420 emits a detection radiation 421 in a direction toward the battery to be detected 411. The radiation source 420 may be an integrated micro-focal spot X-ray source with a rated voltage V satisfying: $130\ kV \leq V \leq 150\ kV$, a rated current I satisfying: $300\ \mu A \leq I \leq 500\ \mu A$, and a focal spot diameter d satisfying: $0 < d \leq 80\ \mu m$.

The flat panel detector 430 is located at the other side of the carrying assembly 410 distal to the radiation source 420. The flat panel detector 430 is configured to receive the detection radiation 421 that is emitted by the radiation source and penetrates the battery to be detected 411. The flat panel detector 430 includes a scintillator layer 431 and a photoelectric conversion layer 432 stacked in the thickness direction. The scintillator layer 431 is configured to receive the detection radiation 421 penetrating the battery to be detected 411 to emit a visible light; the photoelectric conversion layer 432 receives the visible light emitted by the scintillator layer 431 to generate the corresponding electric signal; the scintillator layer 431 includes cesium iodide, the photoelectric conversion layer 432 includes an amorphous silicon thin film transistor, the thickness t of the scintillator layer 431 satisfies: $600\,\mu m \leq t \leq 700\,\mu m$, the density resolution $\beta$ of the flat panel detector 430 satisfies: $0 < \beta \leq 0.38\%$, the ratio $\alpha$ of the output image contrast to the input image contrast of the flat panel detector 430 satisfies: $50\% \leq \alpha < 1$, and the DQE $\lambda$ satisfies: $0.5 \leq \lambda < 1$.

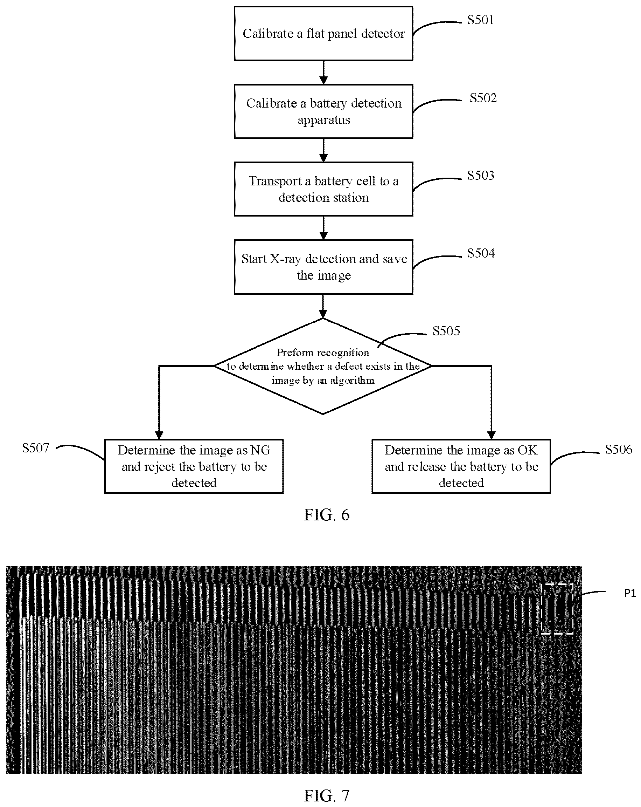

As illustrated in FIG. 6, the detection method of the battery detection apparatus 400 includes the following steps: Step S501: The flat panel detector is calibrated.

To ensure the quality of image detection, the flat panel detector 430 needs to be calibrated before startup. Before calibration, it is necessary to ensure that there are no obstructions between the flat panel detector 430 and the radiation source 420, including the carrying assembly 410 and various debris. The radiation source 420 is turned on for bright-field image acquisition. After the acquisition, the radiation source 420 is turned off for dark-field image acquisition. Nineteen images of each type are acquired. The process is repeated three times. After the calibration, the correction template is re-activated.

Step S502: The battery detection apparatus is calibrated.

Before calibration, it is necessary to ensure that there is no battery to be detected 411 or debris between the radiation source 420 and the flat panel detector 430. A calibration block that is supplied with the device is placed on the detection platform, and the scale of the calibration block is adjusted to maintain the height of a gauge pin installed on the calibration block at half of the height of the battery to be detected 411. The device is turned off, the radiation source 420 is turned on, and the gauge pin is moved to the middle of the screen. The relative position of the radiation source 420 and the flat panel detector 430 is kept consistent with that during battery testing. The software calibration interface is opened, the diameter of the gauge pin is inputted, and the software automatically records and saves the magnification.

Step S503: The battery to be detected is conveyed to a detection station.

The carrying assembly 410 is driven to move to sequentially convey the batteries to be detected 411 to a detection position between the radiation source 420 and the flat panel detector 430, and stops moving to wait for the X-ray to be turned on for detection.

Step S504: The X-ray detection is started and the image is saved.

After the rated voltage and the rated current of the radiation source 420 during detection is set, the X-ray is turned on to penetrate the battery to be detected 411. The flat panel detector 430 receives the X-ray penetrating the battery to be detected 411 and converts the X-ray into an image. Then, the processor reads and saves the image.

Step S505: Recognition is performed to determine whether a defect exists in the image by an algorithm.

The overhang of the anode electrode plate over the cathode electrode plate and the gap between the cathode electrode plate and the anode electrode plate in the battery to be detected 411 in the image is recognized and measured by the deep learning algorithm. The specific determination steps include:

Step S506: The image is determined as OK and the battery to be detected is normally released. If it is detected in the image that the overhang of the anode electrode plate over the cathode electrode plate and the gap between the cathode electrode plate and the anode electrode plate are within the preset threshold range, the image is determined as OK, and the corresponding battery to be detected 411 is normally released.

Step S507: The image is determined as NG and the battery to be detected is rejected. If it is detected that the overhang of the anode electrode plate over the cathode electrode plate and/or the gap between the cathode electrode plate and the anode electrode plate exceeds the preset threshold range, the image is determined as NG, and the corresponding battery to be detected 411 is automatically rejected to prevent the defective products from being released.

According to the description in the above embodiments, in some embodiments, the density contrast U of the battery to be detected 411 with 76 electrode plate winding turns is 0.39%. With all other conditions kept consistent, the performance indicators of the flat panel detector 430 under different thicknesses of the scintillator layer 431 are shown in the following table:

| Thickness t of scintillator layer ($\mu$m) | DQE $\lambda$ | MTF $\alpha$ | Density resolution $\beta$ |
|---|---|---|---|
| 150 | 0.23-0.33 | 81% | 1.07% |
| 400 | 0.5-0.7 | 72% | 0.5% |

(continued)

| Thickness t of scintillator layer ($\mu$m) | DQE $\lambda$ | MTF $\alpha$ | Density resolution $\beta$ |
|---|---|---|---|
| 500 | 0.53-0.72 | 69% | 0.44% |
| 600 | 0.55-0.75 | 67% | 0.41% |
| 700 | 0.6-0.8 | 58.2% | 0.37% |
| 1000 | 0.65-0.83 | 43.6% | 0.35% |

As can be seen from the above table, when the thickness of the scintillator layer is no more than 400 $\mu$m, for example, 150 $\mu$m, the DQE is relatively low at only 0.23 to 0.33, and the density resolution is relatively high at 1.07%. Therefore, it is difficult to meet the density resolution requirement for the ultra-thick battery to be detected, for example, a battery cell with no less than 47 electrode plate winding turns. However, when the thickness of the scintillator layer is 1000 $\mu$m, the MTF is only 43.6%, and the MTF continues to decrease along with the thickness of the scintillator layer. This, in turn, affects the spatial resolution of the flat panel detector, making it difficult to accurately distinguish the boundaries of adjacent fine structures of the electrode plate, thereby affecting the accuracy and reliability of the image recognition result. In some embodiments of the present application, limiting the thickness of the scintillator layer between 400 $\mu$m and 1000 $\mu$m enables the spatial resolution and the density resolution of the flat panel detector to be well taken into account. In some other embodiments, limiting the thickness of the scintillator layer between 600 $\mu$m and 700 $\mu$m can better meet the requirements for the detection precision of the ultra-thick battery cell with no more than 76 winding turns. Further preferably selecting the rated voltage, the rated current, and the focal spot size of the radiation source allows better cooperation between the radiation source and the flat panel detector of the battery detection apparatus, so as to further improve the resolution and the image quality of the detection image, by the battery detection apparatus, for the battery to be detected with a large thickness, thereby helping to improve the accuracy of the detection results of the battery to be detected.

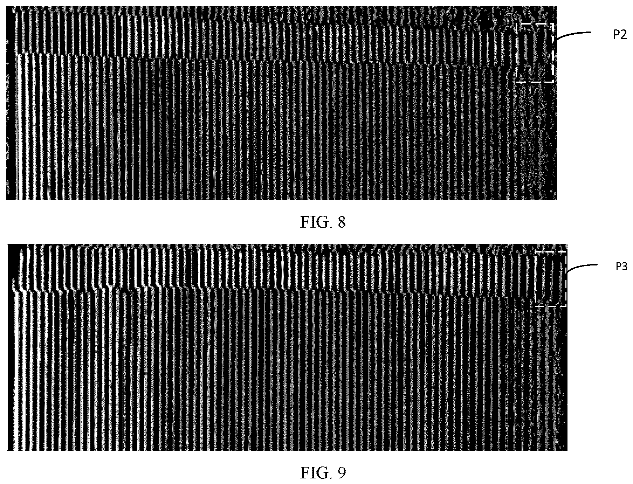

FIG. 7 shows a detection image obtained when the thickness of the scintillator layer 431 of the flat panel detector 430 of the battery detection apparatus 400 is 400 $\mu$m and the number of electrode plate winding turns of the battery to be detected 411 is 76. FIG. 8 shows a detection image obtained when the thickness of the scintillator layer 431 of the flat panel detector 430 of the battery detection apparatus 400 is 600 $\mu$m and the number of electrode plate winding turns of the battery to be detected 411 is 76. FIG. 9 shows a detection image obtained when the thickness of the scintillator layer 431 of the flat panel detector 430 of the battery detection apparatus 400 is 700 $\mu$m and the number of electrode plate winding turns of the battery to be detected 411 is 76.

As illustrated in FIGs. 7 to 9, regions P1, P2, and P3 in the detection image are all regions where one end of the electrode plates in the innermost winding layer in the battery to be detected 411 is located. It can be seen that, in FIG. 7, the end point position of the electrode plates in the innermost winding layer in the region P1 appears blurry, making it difficult to determine the end point position and center position of the electrode plates through algorithms during image recognition. Thus, accurate detection parameters, such as the overhang of the anode electrode plate over the cathode electrode plate and the gap between the cathode electrode plate and the anode electrode plate, cannot be calculated. This indicates that the flat panel detector 430 cannot distinguish the electrode plate in the innermost winding layer from the surrounding structures based on contrast; that is, the density resolution fails to meet the detection requirements. The position of the electrode plate in region P2 in FIG. 8 is clearer than that in region P1. The position information of the electrode plate can be basically determined through an image recognition algorithm, so as to roughly determine whether defects exist in the battery to be detected. The position of the electrode plate in region P3 in FIG. 9 are clearer, which can well show the position information of the cathode electrode plate in the innermost winding layer, including the end point. This is conducive to accurately acquiring corresponding parameters during image recognition, such as the overhang of the anode electrode plate over the cathode electrode plate and the gap between the cathode electrode plate and the anode electrode plate, thereby accurately determining whether the battery to be detected meets the corresponding quality requirements.

Finally, it should be noted that the above embodiments are only used to illustrate the technical solutions of the present application, but not to limit them. Although the present application has been described in detail with reference to the foregoing embodiments, those of ordinary skill in the art should understand that they can still make modifications to the technical solutions recorded in the foregoing embodiments or make equivalent substitutions for some or all of the technical features. However, these modifications or substitutions do not make the essence of the corresponding technical solutions deviate from the scope of the technical solutions in the embodiments of the present application, and these modifications or substitutions shall all fall within the scope of claims and specification of the present application. In particular, the technical features mentioned in the embodiments may be combined in any manner as long as there are no structural conflicts. The present application is not limited to the specific embodiments disclosed herein, but encompasses all the technical solutions that fall within the scope of the claims.

**Claims**

1. A battery detection apparatus, comprising:

   a carrying assembly configured to carry a battery to be detected;
   a radiation source located on one side of the carrying assembly, wherein the radiation source emits a detection radiation in a direction toward the battery to be detected; and
   a flat panel detector located on the other side of the carrying assembly distal to the radiation source, wherein the flat panel detector is configured to receive the detection radiation that is emitted by the radiation source and penetrates the battery to be detected, the flat panel detector comprises a scintillator layer, and a thickness of the scintillator layer is greater than a first preset thickness, such that a density resolution of the flat panel detector is less than 0.5%.

2. The battery detection apparatus according to claim 1, wherein the thickness of the scintillator layer is less than a second preset thickness, such that a ratio $\alpha$ of an output image contrast to an input image contrast of the flat panel detector satisfies: $50\% \leq \alpha < 1$.

3. The battery detection apparatus according to claim 1 or 2, wherein a detective quantum efficiency $\lambda$ of the flat panel detector satisfies: $0.5 \leq \lambda < 1$.

4. The battery detection apparatus according to any one of claims 1 to 3, wherein the thickness t of the scintillator layer satisfies: $400\ \mu m < t < 1000\ \mu m$.

5. The battery detection apparatus according to claim 4, wherein the thickness t of the scintillator layer satisfies: $600\ \mu m \leq t \leq 700\ \mu m$.

6. The battery detection apparatus according to any one of claims 1 to 5, wherein the density resolution $\beta$ of the flat panel detector satisfies: $0 < \beta \leq 0.38\%$.

7. The battery detection apparatus according to any one of claims 1 to 6, wherein the flat panel detector further comprises a photoelectric conversion layer stacked with the scintillator layer, the scintillator layer comprises cesium iodide, and the photoelectric conversion layer comprises an amorphous silicon thin film transistor.

8. The battery detection apparatus according to any one of claims 1 to 7, wherein a rated voltage V of the radiation source satisfies: $130\ kV \leq V \leq 150\ kV$, and/or
   a rated current I of the radiation source satisfies: $300\ \mu A < I \leq 500\ \mu A$.

9. The battery detection apparatus according to any one of claims 1 to 8, wherein a maximum size d of a focal spot of the radiation source satisfies: $0 < d \leq 80\ \mu m$.

10. The battery detection apparatus according to any one of claims 1 to 9, further comprising:
    a processor connected to the flat panel detector, wherein the processor is configured to receive an electric signal from the flat panel detector to output a detection result of the battery to be detected.

11. A flat panel detector, comprising a scintillator layer and a photoelectric conversion layer stacked in a thickness direction, wherein

    the scintillator layer is configured to receive a detection radiation to emit a visible light;
    the photoelectric conversion layer receives the visible light emitted by the scintillator layer to generate a corresponding electric signal;
    a thickness of the scintillator layer is greater than a first preset thickness, such that a density resolution of the flat panel detector is less than 0.5%.

12. The flat panel detector according to claim 11, wherein the thickness of the scintillator layer is less than a second preset thickness, such that a ratio $\alpha$ of an output image contrast to an input image contrast of the flat panel detector satisfies: $50\% \leq \alpha < 1$.

13. The flat panel detector according to claim 11 or 12, wherein the thickness t of the scintillator layer satisfies: $600\ \mu m \leq t \leq$

700 $\mu$m, a detective quantum efficiency $\lambda$ of the flat panel detector satisfies: $0.5 \leq \lambda < 1$, and the density resolution $\beta$ of the flat panel detector satisfies: $0 < \beta \leq 0.38\%$.

14. A battery production device, comprising the battery detection apparatus according to any one of claims 1 to 10.

15. A battery detection method using the battery detection apparatus according to any one of claims 1 to 10, comprising:

conveying the battery to be detected to a detection station;
acquiring a detection image of the battery to be detected; and
recognizing the detection image to determine whether a defect exists in the battery to be detected.

1000

FIG. 1

100

FIG. 2

FIG. 3

400

420

421

411

410

430

440

FIG. 4

421

431

430

432

t

FIG. 5

Calibrate a flat panel detector — S501

Calibrate a battery detection apparatus — S502

Transport a battery cell to a detection station — S503

Start X-ray detection and save the image — S504

S505
Preform recognition to determine whether a defect exists in the image by an algorithm

S507 — Determine the image as NG and reject the battery to be detected

Determine the image as OK and release the battery to be detected — S506

FIG. 6

P1

FIG. 7

FIG. 8

FIG. 9

## INTERNATIONAL SEARCH REPORT

International application No.

**PCT/CN2023/141986**

**A.      CLASSIFICATION OF SUBJECT MATTER**

G01N23/04(2018.01)i

According to International Patent Classification (IPC) or to both national classification and IPC

**B.      FIELDS SEARCHED**

Minimum documentation searched (classification system followed by classification symbols)

IPC： G01N 23，H01M 10

Documentation searched other than minimum documentation to the extent that such documents are included in the fields searched

Electronic data base consulted during the international search (name of data base and, where practicable, search terms used)

CNTXT, ENTXTC, VEN: 电池, 平板探测器, 闪烁体, 密度分辨率, 对比度分辨率, 量子效率, 厚度, battery, flat panel detector, scintillator, density resolution, contrast resolution, quantum efficiency, thickness

**C.      DOCUMENTS CONSIDERED TO BE RELEVANT**

| Category* | Citation of document, with indication, where appropriate, of the relevant passages | Relevant to claim No. |
|---|---|---|
| Y | CN 101997135 A (TOSHIBA IT & CONTROL SYSTEMS CORP.) 30 March 2011 (2011-03-30)<br>description, paragraphs 32, 38 and 239 | 1-15 |
| Y | US 2013119258 A1 (SCHULZ REINER FRANZ et al.) 16 May 2013 (2013-05-16)<br>description, paragraph 0006 | 1-15 |
| Y | RU 2117315 C1 (MEDTEKH et al.) 10 August 1998 (1998-08-10)<br>description, page 3, lines 40-47 | 2, 12 |
| A | CN 108387594 A (CHINA ELECTRIC POWER RESEARCH INSTITUTE CO., LTD.) 10 August 2018 (2018-08-10)<br>entire document | 1-15 |
| A | CN 217820088 U (SHENZHEN DACHENG PRECISION EQUIPMENT CO., LTD. et al.) 15 November 2022 (2022-11-15)<br>description, paragraphs 29-33, and figures 1-2 | 1-15 |
| A | US 2015153462 A1 (SIEMENS AG) 04 June 2015 (2015-06-04)<br>entire document | 1-15 |

☑ Further documents are listed in the continuation of Box C.          ☑ See patent family annex.

| | | |
|---|---|---|
| *     Special categories of cited documents: | "T" | later document published after the international filing date or priority date and not in conflict with the application but cited to understand the principle or theory underlying the invention |
| "A"   document defining the general state of the art which is not considered to be of particular relevance | | |
| "D"   document cited by the applicant in the international application | "X" | document of particular relevance; the claimed invention cannot be considered novel or cannot be considered to involve an inventive step when the document is taken alone |
| "E"   earlier application or patent but published on or after the international filing date | | |
| "L"   document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O"   document referring to an oral disclosure, use, exhibition or other means | "&" | document member of the same patent family |
| "P"   document published prior to the international filing date but later than the priority date claimed | | |

| Date of the actual completion of the international search | Date of mailing of the international search report |
|---|---|
| **24 January 2024** | **01 March 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/141986** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2021096089 A1 (HONDA MOTOR CO., LTD.) 01 April 2021 (2021-04-01)<br>entire document | 1-15 |

Form PCT/ISA/210 (second sheet) (July 2022)

**INTERNATIONAL SEARCH REPORT**
Information on patent family members

International application No.

**PCT/CN2023/141986**

| Patent document cited in search report | | | Publication date (day/month/year) | Patent family member(s) | | | Publication date (day/month/year) |
|---|---|---|---|---|---|---|---|
| CN | 101997135 | A | 30 March 2011 | KR | 20110014947 | A | 14 February 2011 |
| | | | | KR | 101121259 | B1 | 22 March 2012 |
| | | | | JP | 2011039014 | A | 24 February 2011 |
| US | 2013119258 | A1 | 16 May 2013 | DE | 102011075520 | A1 | 15 November 2012 |
| RU | 2117315 | C1 | 10 August 1998 | | None | | |
| CN | 108387594 | A | 10 August 2018 | | None | | |
| CN | 217820088 | U | 15 November 2022 | | None | | |
| US | 2015153462 | A1 | 04 June 2015 | DE | 102012210487 | B3 | 24 December 2013 |
| | | | | WO | 2013189673 | A1 | 27 December 2013 |
| | | | | US | 2016042827 | A1 | 11 February 2016 |
| | | | | US | 9291722 | B2 | 22 March 2016 |
| US | 2021096089 | A1 | 01 April 2021 | JP | 2021056136 | A | 08 April 2021 |
| | | | | JP | 7098591 | B2 | 11 July 2022 |
| | | | | US | 11598731 | B2 | 07 March 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202321708514